# EUROPÄISCHE PATENTSCHRIFT

(11) **EP 0 999 729 B1**
(45) Veröffentlichungstag und Bekanntmachung des Hinweises auf die Patenterteilung: **31.08.2011**
(21) Anmeldenummer: 99121094.9
(22) Anmeldetag: 22.10.1999
(51) Int. Cl.: B23K 1/005, H01L 21/60

(54) **Verfahren zum Laserlöten und zur Temperaturüberwachung von Halbleiterchips sowie nach diesem Verfahren hergestellte Chipkarte**
Process for laser soldering and for temperature monitoring of semi-conductor chips, and chip cards manufactured according to this process
Procédé pour le soudage au laser et pour la surveillance de chips semi-conducteurs, ainsi que les cartes à chips fabriquées selon ce procédé

(30) Priorität: 03.11.1998 DE 19850595
(43) Veröffentlichungstag der Anmeldung: 10.05.2000
(73) Patentinhaber: Hahn-Schickard-Gesellschaft für angewandte Forschung e.V., 78052 Villingen-Schwenningen (DE)
(72) Erfinder: Alavi, Mani, Dr. rer. nat., Dipl.-Ing., 78050 Villingen-Schwenningen (DE); Scheithauer, Hermann, Dipl.-Phys., 78073 Bad Dürrheim (DE); Schmidt, Bertram, Prof. Dr. Dipl.-Phys., 78052 Villingen-Schwenningen (DE); Schumacher, Axel, Dipl.-Phys., 78083 Dauchingen (DE)
(74) Vertreter: Patentanwälte Westphal, Mussgnug & Partner

(56) Entgegenhaltungen:
- DE-A- 3 701 013
- US-A- 4 278 867
- US-A- 4 404 453

## Beschreibung

Die Erfindung betrifft ein Verfahren zum Laserlöten von Halbleiterchips gemäß den Merkmalen des Oberbegriffs des Anspruchs 1. Ein solches Verfahren ist z. B. in US-A-4278867 beschrieben.

Verfahren zum Laserlöten und zur Temperaturüberwachung von Halbleiterchips sind auch in den Dokumenten DE 36 06 764 A1, DE 39 03 860 A1, DE 37 01 013 C2 und DE 38 29 350 A1 beschrieben. Bei diesen bekannten Laserlöten, oder auch Mikrolöten genannt, wird mit Hilfe eines Nd:YAG Laserstrahls nacheinander jede Lötstelle und das darauf aufgebrachte Lot erhitzt, bis dieses schmilzt und eine Kontaktstelle eines Substrates oder einer Chipkarte mit einer Kontaktstelle des Halbleiterchips verlötet ist. Der Lötvorgang wird dadurch überwacht, dass die Wärmeabstrahlung des erhitzten Lotes an der gerade vom Laserstrahl erwärmten Lötstelle mit einem Infrarot-Detektor gemessen und aus dem Messsignal die beim Erreichen des Lot-Schmelzpunktes entstehende Unstetigkeit zur Unterbrechung des Erhitzungsvorgangs herangezogen wird.

In der bereits genannten DE 37 01 013 C2 wird vorgeschlagen, den Laserstrahl durch ein für Laserlicht durchlässiges Substrat, auf das der Chip gelötet wird, auf die Lötstellen zu richten. Hierdurch können auch SMD-Bauelemente sicher verlötet werden.

Problematisch bei diesem bekannten Laserlötverfahren ist die Tatsache, dass jede Lötstelle vom Laserstrahl einzeln angefahren werden muss und der komplette Lötvorgang erst dann abgeschlossen ist, wenn sämtliche Lötstellen nacheinander vom Laserstrahl erhitzt worden sind. Dieses Verfahren ist damit verhältnismäßig zeitaufwändig. Es hat sich darüber hinaus herausgestellt, dass der Infrarot-Detektor ein Signal für einen Temperaturverlauf bereitstellt, aus dem nicht oder nur unter groβen Schwierigkeiten und damit unzuverlässig der genaue Schmelzpunkt des Lotes ermittelbar ist. Dies liegt in erster Linie daran, dass der Infrarot-Detektor selbst auf das Lot gerichtet ist. Die Oberfläche des Lotes verändert sich jedoch bei Erwärmung, sodass das Wärmesignal verfälscht ist. Im Übrigen ist das bei der Infrarottemperaturmessung des Lotes erhaltene Signal verhältnismäßig schwach, weil der Emissionskoeffizient von Lötmaterialien, wie z. B. Lötzinn, etwa nur bei 10% liegt.

Ein anderes bekanntes Verfahren zum Löten von Halbleiterchips auf Kontaktstellen eines Substrates oder eines Trägers ist das so genannte Flip-Chip-Löten. Bei diesem Flip-Chip-Löten wird der Chip auf dem Trägerkörper vorfixiert und das Lot an die Kontaktstellen gebracht. In einem anschließenden Erwärmungsvorgang wird der Chip samt Trägerkörper auf eine ausreichend hohe Temperatur erwärmt, sodass das Lot schmelzen kann. Anschließend wird der Chip und der Trägerkörper wieder abgekühlt, sodass sich das Lot erhärtet und die gewünschten elektrischen Kontakte hergestellt sind.

Problematisch bei diesem Flip-Chip-Löten ist die Tatsache, dass sowohl der Halbleiterchip als auch der Trägerkörper erhitzt und daher verhältnismäßig hohen Temperaturen über längere Zeit ausgesetzt werden. Dies kann zu Schädigungen des Halbleiterchips aber auch zu Schädigungen des Trägerkörpers führen.

Eine Kombination beider Verfahren lehrt die eingangs genannte Druckschrift US 4,278,867, in der mittels eines Lasers auf einem vorgeheizten Substrat der zum Schmelzen des Lotes nötige Energieeintrag generiert wird, wobei durch Anpassung des Wellenlängebereiches die Wärmequellen auf die Chipoberfläche verlegt werden.

Eine Erhitzung des Trägerkörpers ist insbesondere dann zu vermeiden, wenn es sich um einen so genannten Niedertemperatur-Trägerkörper handelt. Solche Niedertemperatur-Trägerkörper sind beispielsweise die aus Kunststoff bestehenden Chipkarten.

Hier setzt die vorliegende Erfindung an.

Das Ziel der Erfindung besteht darin, ein Verfahren zum Laserlöten von Halbleiterchips anzugeben, welches im Vergleich zu den bisherigen Verfahren sowohl zeitlich schneller als auch hinsichtlich der Temperaturbelastung des Halbleiterchips und des Trägerkörpers unkritischer ist.

Dieses Ziel wird durch ein Verfahren zum Laserlöten von Halbleiterchips gelöst, wie es in Anspruch 1 angegeben ist.

Weiterbildungen der Erfindung sind Gegenstand der auf diese Ansprüche zurückbezogenen Unteransprüche.

Das erfindungsgemäße Verfahren zum Laserlöten von Halbleiterchips nach der Erfindung ist im Anspruch 1 angegeben. Es besteht im Wesentlichen darin, dass der Laserstrahl auf die den Lötstellen abgewandte Rückseite des gehäusefreien Halbleiterchips gerichtet wird. Der Laserstrahl wird also im Gegensatz zu dem bekannten Verfahren nicht auf die Lötstelle selbst oder auf das dort befindliche Lot gerichtet, sondern auf das gehäusefreie Halbleiterchip. Der Halbleiterchip erwärmt sich und fungiert als Wärmeleiter für das Lot, sodass das auf der Unterseite des Halbleiterchips an den jeweiligen Kontaktstellen des Halbleiterchips angebrachte Lot schmelzen kann. Es werden also sämtliche Lötstellen gleichzeitig durch die Erwärmung des Halbleiterchips geschmolzen, sodass die Lötkontakte sehr schnell hergestellt werden können.

Gemäß der Erfindung ist dabei vorgesehen, dass die Laserbestrahlung des Halbleiterchips für etwa 0,1 bis 0,5 sec durchgeführt wird. Versuche haben gezeigt, dass diese sehr kurze Zeitspanne ausreichend ist, um den Halbleiterchip soweit zu erhitzen, dass dessen darunter befindliches Lot sicher aufschmilzt. Dieses sehr kurzzeitige Erhitzen des Halbleiterchips stellt sicher, dass die Funktionen des Halbleiterchips erhalten bleiben. Versuche bei der Anmelderin haben ergeben, dass kein Halbleiterchip nach dem erfolgten Lötvorgang in seiner Funktionsweise beeinträchtigt war.

Das Lötverfahren nach dieser Lösung wird dazu genutzt, sämtliche Lötstellen auf dem Halbleiterchip simultan zu löten. Hierbei wird die hohe Wärmeleitfähigkeit des Halbleitermaterials des Halbleiterchips ausgenutzt. Als Halbleitermaterial kommt bevorzugt Silizium zur Anwendung. Es können jedoch auch andere Halbleitermaterialien, wie z. B. Galliumarsenid oder dergleichen, vorgesehen werden. Die hohe Wärmeleitfähigkeit des Halbleitermaterials des Halbleiterchips führt bei typischen Chipabmessungen von wenigen Quadratmillimetern zu einer praktisch gleichförmigen Erwärmung des Halbleiterchips. Durch das gleichzeitige Löten sämtlicher Lötstellen tritt vorteilhafterweise kein so genannter "Grabstein-Effekt" auf. Hierunter versteht man das Aufrichten des Chips bzw. des zu lötenden Bauteiles, nachdem eine Lötstelle am Rand realisiert ist.

Ein sehr wesentlicher und sehr wichtiger Vorteil bei dem Laserlötverfahren besteht in der sehr geringen Temperaturbelastung des Trägerkörpers bzw. des Substrates, auf das der Halbleiterchip gelötet wird. Ist der Trägerkörper ein Niedertemperaturträgerkörper, wie dies beispielsweise die Chipkartenträgerkörper sind, so ertragen diese lediglich Temperaturen von 60 bis 70°C, wenn die Erwärmung länger als 1 sec dauert. Es hat sich herausgestellt, dass das erfindungsgemäße Lötverfahren ideal auch zum Auflöten von Halbleiterchips auf solche Niedertemperatursubstrate geeignet ist. Dies ist deshalb möglich, weil auf dem Substrat metallische Leiterbahnen vorhanden sind, auf welche der Halbleiterchip gelötet wird. Die metallischen Leiterbahnen treten als Wärmesenke auf und verhindern eine Schädigung des Substrates. Die zum Löten erforderliche Temperatur von etwa 250 bis 300°C am Lötpunkt wird erfindungsgemäß jedoch nur für etwa 0,1 sec bis maximal 0,5 sec benötigt. Dieses sehr kurzzeitige Erwärmen der Lötstellen sorgt in Verbindung mit den metallischen Leiterbahnen auf dem Substrat dafür, dass dieses nicht beeinträchtigt wird.

Die erforderliche Laserleistung liegt im Bereich mehrerer Watt. Der Fokus des Laserstrahls auf der Rückseite des Halbleiterchips hat erfindungsgemäß einen Durchmesser von 0,1 bis 2 mm. Dies reicht aus, um den Halbleiterchip ganzflächig oder nahezu ganzflächig zu erwärmen, sodass dieser als guter Wärmeleiter die Temperaturerhöhung an die Lötstellen weitergeben kann.

Der Zeitpunkt, wann die Wärmezufuhr durch die Laserbestrahlung unterbrochen wird, kann prinzipiell auf herkömmliche und damit bekannte Art und Weise erfolgen. Dies bedeutet, dass mit einem Infrarot-Detektor die Temperatur der Lötstellen oder zumindest einer der Lötstellen erfasst wird.

Bei vorliegender Erfindung wird der Zeitpunkt des Schmelzens des Lotes auf zuverlässigere Art erfasst. Hierfür wird ebenfalls ein infrarotempfindlicher Sensor eingesetzt, um das Erreichen des Schmelzpunktes des Lotes zu überwachen. Bei Erreichen des Schmelzpunktes wird ein Signal zur Laserstrahlunterbrechung an eine Steuereinrichtung geleitet, die das Laserlicht nach einer festgelegten Zeit, in der der Benetzungsvorgang stattfindet, abschaltet. Erfindungsgemäß wird der Infrarot empfindliche Sensor auf die Rückseite des gehäusefreien Halbleiterchips gerichtet. Durch diese berührungslose Infrarottemperaturmessung der Temperatur der Rückseite des Halbleiterchips ergibt sich ein wesentlich stärkeres Temperatursignal als bei der Erfassung einzelner Lötstellen. Dies unter anderem auch deswegen, weil der Emissionskoeffizient des Siliziums je nach Oberflächenrauhigkeit etwa 45% bis 90% beträgt, der des Lotes aber nur etwa 10%. Zudem, und dies ist besonders wichtig, bleibt die als Wärmespiegel wirkende Rückseite des Halbleiterchips geometrisch konstant, sodass das Wärmesignal nicht durch veränderliche, aufschmelzende Oberflächen beeinträchtigt wird, wie dies bei der direkten Temperaturmessung der Lötstelle der Fall wäre.

Da während des Laserlötvorganges der Temperatur-Zeit-Verlauf sehr sicher erfasst wird, kann die Laserbestrahlung zuverlässig gestoppt werden, sobald der Lötvorgang beendet ist. Das Schmelzen ist im Temperatur-Zeit-Verlauf an einer auftretenden Unstetigkeit, d. h. an einer abrupten Änderung des Anstieges des Temperatur-Zeit-Verlaufes zu erkennen, weil einerseits der Phasenübergang beim Schmelzen des Lotes Wärme verbraucht und andererseits durch die entstehende Lötverbindung die Wärmeleitung zu den als Wärmesenke wirkenden Metallleiterbahnen auf dem Trägerkörper bzw. Substrat deutlich vergrößert wird.

Diese abrupte Änderung des Anstieges des Temperatur-Zeit-Verlaufes kann sehr sicher detektiert werden, wenn dieser Kurvenverlauf vorzugsweise durch Frequenzfilterung vom Rauschen befreit und anschließend nach der Zeit differenziert wird, also die erste Ableitung des Temperatur-Zeit-Verlaufes gebildet wird. In diesem differenzierten Signalverlauf ist die abrupte Änderung des Anstieges des Temperatur-Zeit-Verlaufes nach wenigen Millisekunden durch eine Unstetigkeitsstelle oder einen Wendepunkt bestimmt.

Bei dem erfindungsgemäßen Verfahren wird ein Substrat mit metallischen Kontaktflächen bereitgestellt, und der Halbleiterchip mit seinen Lötstellen über diesen Kontaktflächen platziert. Die Lötstellen werden dann mit diesen Kontaktflächen verlötet. Das Substrat ist erfindungsgemäß ein Niedertemperatursubstrat und insbesondere der Trägerkörper für eine Chipkarte. Das Substrat besteht dabei aus Kunststoff.

In einer bevorzugten Anwendung der Erfindung, wird der Halbleiterchip auf dem Substrat vor dem Laserlötvorgang vorfixiert. Dies ist jedoch nicht zwingend.

Das erfindungsgemäße Verfahren und eine Chipkarte, die nach diesem Verfahren hergestellt wird, werden nachfolgend im Zusammenhang mit drei Figuren beispielhaft näher erläutert. Es zeigen:
- Figur 1: Die schematische Schnittdarstellung eines auf einem Niedertemperatursubstrat aufgesetzten Halbleiter- chips, das nach dem erfindungsgemäßen Verfahren auf das Niedertemperatursubstrat gelötet wird,
- Figur 2: einen ersten Kurvenverlauf des Temperatur-Zeit- Verhaltens der Rückseite des Halbleiterchips, und
- Figur 3: weitere Beispiele von Temperatur-Zeit-Verläufen und deren zugehörende differenzierten Kurvenverläufe.

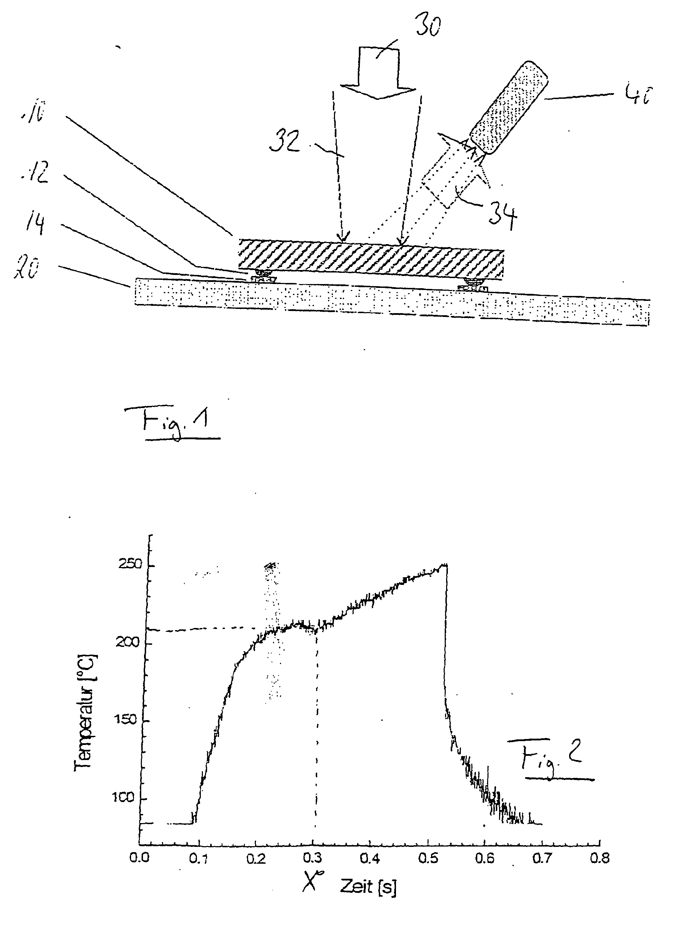

In Figur 1 ist schematisch die Schnittdarstellung eines Halbleiterchips 10 dargestellt, der auf einem Niedertemperatursubstrat 20 sitzt. Das Niedertemperatursubstrat 20 kann beispielsweise eine aus Kunststoff bestehende, Scheckkartengröße aufweisende Trägerkarte sein, die später als Chipkarte fungiert, wenn das Halbleiterchip 10 fertig montiert ist. Das Niedertemperatursubstrat 20 weist auf seiner Oberseite Kontaktflächen 14 auf, die aus Metall, wie z. B. Gold oder Kupferbahnen etc., bestehen. Der Halbleiterchip 10, vorzugsweise ein Siliziumchip, verfügt an seiner Unterseite und damit der dem Niedertemperatursubstrat 20 zugewandten Fläche über Kontaktstellen, auf denen bereits Lotbumps aufgebracht sind. Das Lot bzw. die Lotbumps sind mit dem Bezugszeichen 12 versehen. Obwohl in Figur 1 nur zwei Kontaktflächen 14 und zwei Lotbumps 12 dargestellt sind, kann der Halbleiterchip 10 und das Niedertemperatursubstrat 20 über eine Vielzahl solcher zu kontaktierenden Stellen aufweisen.

Um das Lot 12 auf die Kontaktflächen 14 des Niedertemperatursubstrats 20 zu löten, wird mit Hilfe eines Laserstrahls 32 einer Laserlichtquelle 30 die Rückseite, d. h. die dem Niedertemperatursubstrat 20 abgewandte Oberfläche des Halbleiterchips 10 erwärmt. Hierfür wird der Laserstrahl 32 so auf die Rückseite des Halbleiterchips 10 gestrahlt, dass dort ein Fokus von etwa 0,1 mm bis 2 mm Durchmesser auftrifft. Dies ist ausreichend für eine sichere Erwärmung des gesamten Halbleiterchips 10. Die erforderliche Laserleistung liegt im Bereich mehrerer Watt, z. B. 10 Watt. Zur Anwendung kommen u. a. Nd:YAG-Laser und Diodenlaser im cw-Betrieb. Typische Wellenlängen liegen zwischen 800 und 1100 nm.

Nachdem die Laserlichtquelle 30 eingeschaltet ist und der Laserstrahl 32 auf die Rückseite des Halbleiterchips 10 strahlt, erwärmt sich dieser und gibt diese Erwärmung an die Lotbumps 12 weiter. Bei ausreichender Erhitzung schmilzt das Lot 12. Dieser Zeitpunkt wird mit einem infrarotempfindlichen Sensor 40 detektiert.

Der Temperatursensor 40 ist ebenfalls auf die Rückseite des Halbleiterchips 10 gerichtet und detektiert dessen Wärmeabstrahlung. Die Oberfläche des Halbleiterchips 10 wirkt somit als Wärmespiegel. Die vom Temperatursensor 40 erfasste Wärmestrahlung ist in Figur 1 mit dem Bezugszeichen 34 versehen.

In Figur 2 ist ein typischer Kurvenverlauf des Temperatur-Zeit-Verhaltens, wie er von dem Temperatursensor 40, der ein Infrarotsensor sein kann, gemessen wird, grafisch dargestellt. Auf der horizontalen Achse ist die Zeit in Sekunden und auf der vertikalen Achse die vom Temperatursensor 40 gemessene Temperatur in Grad Celsius aufgetragen. Es ist deutlich zu erkennen, dass zu Beginn der Laserbestrahlung der Rückseite des Halbleiterchips 10 dessen Temperatur sehr stark ansteigt und nach etwa 0,2 sec etwa eine Temperatur von ca. 200°C erreicht. Anschließend nimmt die Temperatur nur sehr schwach zu, um sich bis zu dem Zeitpunkt von etwa 0,3 sec nicht mehr sehr viel weiter zu erhöhen. Die Temperatur liegt nach 0,3 sec bei etwa 210°C. Anschließend ändert sich jedoch die Steigung der Temperatur ganz deutlich. Die Temperatur steigt linear bis 0,55 sec auf etwa 250°C an. Der Schmelzzeitpunkt des Lotes 12 ist durch die abrupte Änderung des Anstieges der Temperatur gekennzeichnet. Dies ist etwa bei 0,3 sec der Fall.

Sobald der Temperatursensor 40 diese abrupte Änderung im Anstieg der Temperatur erfasst, kann ein Signal an eine Steuereinrichtung abgegeben werden, durch welche der Laserstrahl 32 nach einer festgelegten Zeit unterbrochen wird.

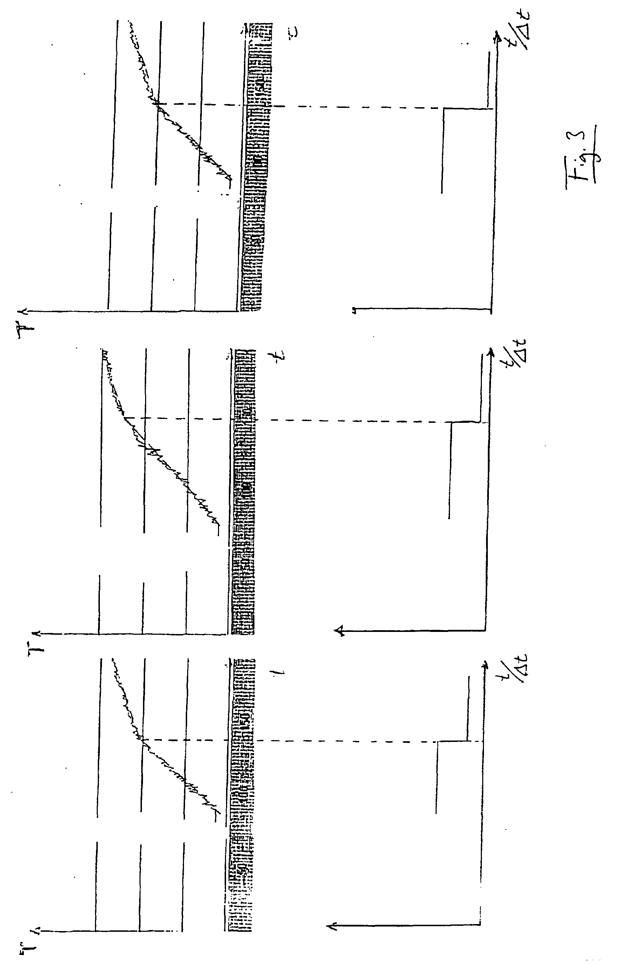

In Figur 3 sind drei weitere Beispiele von konkret gemessenen Temperatur-Zeit-Kurven nebeneinander dargestellt. Sämtliche drei Kurvenverläufe zeichnen sich dadurch aus, dass die Temperatur mit einer verhältnismäßig hohen Steigung bis etwa 0,15 sec linear ansteigt, um dann in einen Kurvenverlauf überzugehen, der zwar linear ansteigt, jedoch weniger stark. Diese abrupte Änderung in der Steigung des Temperaturverhaltens ist wiederum ein konkreter Anhaltspunkt dafür, dass der Schmelzpunkt des Lotes erreicht ist.

In Figur 3 unten ist zu den Temperaturverläufen jeweils die zugehörende erste Ableitung schematisch gezeigt. Die Änderung in der Steigung des Temperaturverhaltens macht sich im Signal der ersten Ableitung durch einen Sprung des differenzierten Signales bzw. durch eine Unstetigkeitsstelle oder einen Wendepunkt bemerkbar. Es bietet sich deshalb an, dass nach der Zeit differenzierte Signal auszuwerten, um den Laserstrahl abzuschalten.

## Patentansprüche

1. Verfahren zum Laserlöten von Halbleiterchips (10), bei welchem ein Substrat (20) mit metallischen Kontaktflächen (14) bereitgestellt wird, der Halbleiterchip (10) mit seinen Lötstellen auf diesen Kontaktflächen (14) angeordnet wird und sämtliche Lötstellen mit diesen Kontaktflächen (14) gleichzeitig verlötet werden, indem ein Laserstrahl (32) auf die Rückseite des gehäusefreien Halbleiterchips (10) so lange gerichtet wird, bis das auf die Lötstellen aufgebrachte Lot (12) geschmolzen ist und anschließend die Laserbestrahlung unterbrochen wird, wobei ein berührungsloser, temperaturempfindlicher Sensor (40) auf die Rückseite des gehäusefreien Halbleiterchips (10) gerichtet wird,
**dadurch gekennzeichnet, dass**
der Sensor (40) den Temperatur-Zeit-Verlauf auf der Rückseite des Halbleiterchips (10) misst und ein entsprechendes Signal an eine Steuereinrichtung weiterleitet, durch welche die Laserbestrahlung bei einer abrupten Änderung des Anstiegs des Kurvenverlaufes unterbrochen wird, und dass als Material für das Substrat (20) Kunststoff gewählt ist.

2. Verfahren nach Anspruch 1 ,
**dadurch gekennzeichnet, dass**
die Leistung der den Laserstrahl (32) bereitstellenden Laserlichtquelle (30) bis zu etwa 10 Watt beträgt.

3. Verfahren nach Anspruch 1,
**dadurch gekennzeichnet, dass**
das Substrat (20) ein Chipkartenträger ist.

4. Verfahren nach einem der Ansprüche 1 bis 3,
**dadurch gekennzeichnet, dass**
der Halbleiterchip (10) auf dem Substrat (20) vor dem Laserlötvorgang vorfixiert wird.

5. Verfahren nach einem der Ansprüche 1 bis 4,
**dadurch gekennzeichnet, dass**
der Halbleiterchip (10) ein Silizium- oder GAs-Chip ist.

6. Verfahren nach einem der Ansprüche 1 bis 5,
**dadurch gekennzeichnet, dass**
die Laser-Lichtstrahlung mit einer Wellenlänge von etwa 800 bis 1100 nm erfolgt.

7. Verfahren nach einem der Ansprüche 1 bis 6,
**dadurch gekennzeichnet, dass**
der Laserstrahl fokussiert mit einem Fokus von etwa 0,1 bis 2 mm Durchmesser und für die Dauer von etwa 0,1 bis 0,5 sec auf die Rückseite der Halbleiterchips (10) gerichtet wird.

## Claims

1. A method of laser soldering semiconductor chips (10), in which a substrate (20) with metallic contact faces (14) is produced, the semiconductor chip (10) is arranged with its soldering points on these contact faces (14) and all the soldering points are soldered simultaneously with these contact faces (14), in that a laser beam (32) is directed onto the rear side of the semiconductor chip (10) free of the casing until the solder (12) applied to the soldering points has melted and then the laser radiation is interrupted, wherein a contact-less temperature-sensitive sensor (40) is directed onto the rear side of the semiconductor chip (10) free of the casing, **characterized in that** the sensor (40) measures the temperature / time pattern on the rear side of the semiconductor chip (10) and transmits a corresponding signal to a control device by which the laser radiation is interrupted in the event of an abrupt change in the ascent of the curve pattern, and plastics material is selected for the material for the substrate (20).

2. A method according to claim 1, **characterized in that** the power of the laser light source (30) producing the laser beam (32) amounts to approximately 10 W.

3. A method according to claim 1, **characterized in that** the substrate (20) is a smart card carrier.

4. A method according to any one of claims 1 to 3, **characterized in that** the semiconductor chip (10) is fixed in advance on the substrate (20) before the laser soldering procedure.

5. A method according to any one of claims 1 to 4, **characterized in that** the semiconductor chip (10) is a silicon or a Gas [*sic*] chip.

6. A method according to any one of claims 1 to 5, **characterized in that** the laser light radiation takes place with a wavelength of from approximately 800 to 1100 nm.

7. A method according to any one of claims 1 to 6, **characterized in that** the laser beam focuses with a focus of from approximately 0.1 to 2 mm diameter and is directed onto the rear side of the semiconductor chip (10) for the duration of from approximately 0.1 to 0.5 sec.

## Revendications

1. Procédé de soudage au laser de puces semi-conductrices (10), procédé selon lequel on utilise un substrat (20) ayant des surfaces de contact métallique (14), la puce semi-conductrice (10) étant installé avec ses points de soudage sur ces surfaces de contact (14) et tous les points de soudage sont soudés simultanément à ces surfaces de contact (14) en dirigeant un faisceau laser (32) sur le dos de la puce semi-conductrice (10) sans boîtier, jusqu'à ce que la soudure (12) appliquée sur les points de soudage soit fondue et ensuite on coupe le faisceau laser,
* un capteur (40) thermosensible, sans contact, étant dirigé sur le dos de la puce semi-conductrice (10) sans boîtier,
procédé **caractérisé en ce que**
le capteur (40) mesure la courbe température/temps au dos de la puce semi-conductrice (10) et transmit un signal correspondant à une installation de commande qui coupe le faisceau laser en cas de variation brusque de la montée de la courbe, et
le matériau du substrat (20) est une matière plastique.

2. Procédé selon la revendication 1,
**caractérisé en ce que**
la puissance de la source de lumière laser (30) générant le faisceau laser (32) atteint environ 10 watt.

3. Procédé selon la revendication 1,
**caractérisé en ce que**
le substrat (20) est un support de carte à puce.

4. Procédé selon l'une des revendications 1 à 3,
**caractérisé en ce que**
la puce semi-conductrice (10) est préfixée sur le substrat (20) avant le soudage par laser.

5. Procédé selon l'une des revendications 1 à 4,
**caractérisé en ce que**
la puce semi-conductrice (10) est une puce en silicium ou en GAs.

6. Procédé selon l'une des revendications 1 à 5,
**caractérisé en ce que**
le faisceau laser a une longueur d'onde de l'ordre 800 à 1100 nm.

7. Procédé selon l'une des revendications 1 à 6,
**caractérisé en ce que**
le faisceau laser est focalisé avec un foyer d'un diamètre de l'ordre de 0,1 à 2 mm et la durée le temps de laquelle il est dirigé sur le dos de la puce semi-conductrice (10) est de l'ordre de 0,1 à 0,5 seconde.
